# FASCICULE DE BREVET EUROPEEN

(11) **EP 1 156 491 B1**
(45) Date de publication et mention de la délivrance du brevet: **23.03.2005**
(21) Numéro de dépôt: 01119573.2
(22) Date de dépôt: 09.01.1997
(51) Int. Cl.: G11C 19/28, G09G 3/36

(54) **Perfectionnement aux registres à décalage utilisant des transistors "mis" de même polarité**
Verbesserungen an Schieberegistern unter alleiniger Verwendung von "MIS" Transistoren
Improvements in shift registers using single type "MIS" transistors

(30) Priorité: 11.01.1996 FR 9600260
(43) Date de publication de la demande: 21.11.2001
(62) Demande divisionnaire de: 97900253.2
(73) Titulaire: Thales Avionics LCD S.A., 75008 Paris (FR)
(72) Inventeur: Maurice, François, 92648 Boulogne cedex (FR); Lebrun, Hugues, 92648 Boulogne cedex (FR); Sanson, Eric, 92648 Boulogne cedex (FR)
(74) Mandataire: Esselin, Sophie

(56) Documents cités:
- FR-A- 2 720 185
- US-A- 5 282 234

## Description

La présente demande est une demande divisionnaire de la demande EP 97 900 253.2.

L'invention décrite dans cette demande concerne les registres à décalage utilisant des transistors "MIS" (pour Métal, Isolant, Semiconducteur) de même polarité. Elle concerne plus particulièrement un perfectionnement aux registres à décalage utilisant un nombre limité de transistor "MIS" de même polarité et permettant la sélection des lignes de pixels d'un écran plat.

Un écran plat, notamment un écran plat à cristaux liquides, est constitué d'un certain nombre de cellules électro-optiques arrangées en lignes et en colonnes commandées chacune par un dispositif de commutation et comportant deux électrodes encadrant un cristal liquide dont les propriétés optiques sont modifiées en fonction de la valeur du champ qui le traverse. L'ensemble constitué par le dispositif de commutation, l'électrode, le cristal liquide, la contre-électrode constitue ce que l'on appelle un "pixel' ou point image. L'adressage de ces pixels s'effectue par l'intermédiaire de lignes de sélection qui commandent l'état passant et non-passant des dispositifs de commutation et de colonnes ou lignes de données qui transmettent, lorsque le dispositif de commutation est passant, une tension appliquée aux bornes des électrodes correspondant au signal de données à afficher, à savoir à une échelle de gris.

Selon un mode de réalisation particulièrement avantageux, les électrodes, les dispositifs de commutation, les lignes et les colonnes sont déposées et gravées sur une même plaque substrat de manière à constituer la matrice active de l'écran. Dans ce cas, les circuits de commande périphérique, c'est-à-dire le balayeur de lignes de sélection qui sélectionne les lignes horizontales à afficher et les circuits qui commandent les colonnes peuvent être directement intégrés sur la plaque substrat comportant la matrice active et labriqués en même temps que celle-ci. Ceux-ci imposent donc, notamment lorsque le nombre de pixels est très élevé, d'avoir des circuits de commande les plus petits et les plus simples possible afin d'arriver à un haut degré de rendement de fabrication. Il peut par ailleurs être avantageux d'utiliser des dispositifs semi-conducteurs comme dispositifs de commutation des pixels du même type de conductivité dans tout l'afficheur.

La commande des dispositifs semi-conducteurs peut être laite par des lignes adressées par un ou plusieurs registres à décalage. Une structure de registre à décalage permettant notamment de répondre aux exigences de simplicité évoquées dans le paragraphe précédent a été décrite dans la demande de brevet internationale WO 92/15992 déposée au nom de THOMSON-LCD. Dans ce cas, un étage d'un registre à décalage comporte six transistors et est alimenté par deux signaux d'horloge ainsi que par deux sources positives et une source négative. Le fonctionnement de ce registre repose sur le lait que la grille du transistor qui commande la sortie de l'étage du registre est laissée flottante et qu'ainsi son potentiel suit, par effet capacitif le potentiel de l'horloge et de la sortie. Cet effet est appelé effet "bootstrap" en langue anglaise. Il permet au moment voulu, la charge complète de la sortie au potentiel le plus élevé de horloge. A ce transistor de sortie sont associés un transistor permettant de précharger ]a grille du transistor de sortie et un transistor permettant de la décharger. D'autre part, le fonctionnement de ces trois transistors est tel que si l'effet "bootstrap" permet une bonne charge des sorties, il s'accompagne d'effets parasites qui nécessitent l'utilisation de trois transistors supplémentaires. Un autre inconvénient réside dans le lait que certains transistors subissent en permanence un stress de grille, à savoir une tension positive sur la grille qui peut avoir pour conséquence une dérive de leur tension de seuil et entraîner à terme un disfonctionnement de l'ensemble du dispositif.

Pour remédier aux inconvénients ci-dessus, on a proposé dans la demande de brevet français n° 94 05987 déposée le 17 mai 1994 au nom de THOMSON-LCD des circuits plus simples à trois ou quatre transistors présentant des durées de vie rallongées.

Ainsi, comme représenté sur la figure 1 qui correspond à la figure 2 de la demande de brevet français N° 94 05987, un étage 21 d'un registre à décalage permettant de commander les lignes de sélection est constitué de trois transistors Tl, Tp et Td. Dans ce cas, le transistor Tl commande le noeud D de la sortie sur la ligne J. Il est préchargé par le transistor Tp et déchargé par le transistor Td. De manière plus précise, l'étage 21 est connecté en 22 à la ligne précédente J-1 par le drain du transistor Tp. La grille du transistor Tp est connectée à son drain tandis que sa source est connectée au point G lui-même connecté à la grille du transistor Tl. D'autre part, le point G est relié à une tension négative V- par l'intermédiaire du transistor de décharge Td, lui-même commandé par le potentiel de la ligne J+1 connectée en sortie de l'étage suivant. De plus, le noeud D est connecté à la source du transistor Tl, au noeud G par l'intermédiaire d'une capacité Cb et à la ligne J à sélectionner dont la charge est symbolisée électriquement par une capacité CI reliée à la masse 32. Un signal d'horloge φ1 est appliqué sur le drain du transistor de sortie TI. Il existe entre le drain et la grille de ce transistor, une capacité parasite Cp responsable de l'effet "bootstrap" expliqué avec référence à la demande WO92/15992. D'autre part dans ce schéma, une horloge φ2 exactement complémentaire de l'horloge φ1 est connectée au noeud G par l'intermédiaire d'une capacité C2 d'une valeur équivalente à celle de la capacité parasite Cp.

Ainsi les effets parasites, conséquence de l'effet "bootstrap" sont contre-balancés grâce à la liaison de l'horloge φ2 (complémentaire de l'horloge φ1) avec la grille du transistor Tp par l'intermédiaire de la capacité C2 de valeur Ct équivalente à celle de Cp. Les deux horloges étant exactement complémentaires, elles n'induisent aucune tension parasite au noeud G, à savoir sur la grille du transistor Tl. Un circuit équivalent comporte une capacité CI = 2 x Ct entre le noeud G et la masse 32. Une telle structure réduisant l'effet « bootstrap », il est nécessaire d'ajouter une capacité "bootstrap" Cb entre le noeud source D et le noeud grille G afin que la tension de la grille suive une fraction Cb/(Cb + 2xCp) des variations de la tension de source. Ainsi, il suffit, pour qu'un ratio de "bootstrap" de 60% soit atteint, que Cb ait trois fois la valeur de Ct. Le circuit décrit ci-dessus conserve l'effet "bootstrap" sans ses effets secondaires. La durée de vie du circuit et donc de l'ensemble du dispositif est rallongée alors que le nombre de transistors nécessaires a été divisé par deux par rapport à l'art antérieur.

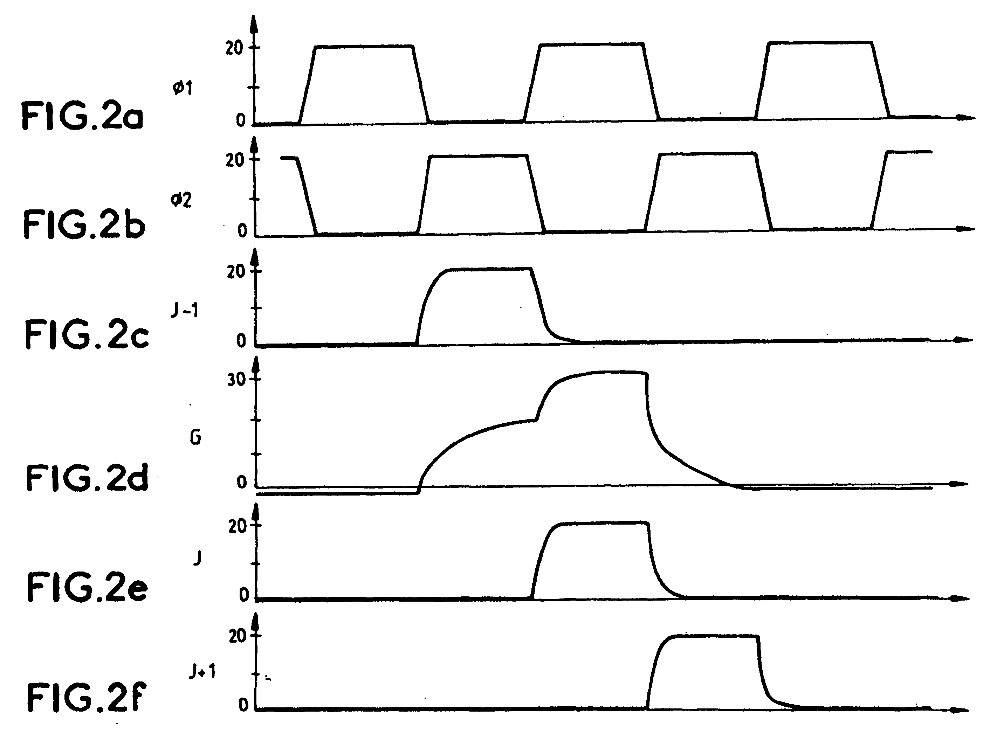

Le fonctionnement du circuit est expliqué avec référence aux chronogrammes 2a à 2f chacun d'eux montrant en abscisse une échelle de temps et en ordonnée un potentiel. Lorsque l'étage J-1 précédent envoie une impulsion (figure 2c) en 22, le transistor de précharge Tp est passant et charge la capacité de "bootstrap" Cb. Le potentiel du noeud G (fig. 2d) monte jusqu'à celui de la ligne J-1 correspondant à l'étage 5 précédent, auquel if faut retrancher sensiblement la valeur de la tension de seuil du transistor Tp. Le transistor TI est alors passant. Lorsque l'horloge φ1 monte à son tour (fig. 2a) la sortie J suit, entraînant la grille du transistor Tl grâce à la capacité de "bootstrap" (fig. 2d). Le transistor Tl est alors largement passant et le noeud D et la ligne J suivent parfaitement le potentiel de l'horloge φ1 (fig. 2e) jusqu'à sa descente. A ce moment, la ligne suivante J+1 monte (fig. 2f) et rend passant le transistor Td qui décharge la capacité de "bootstrap" Cb de sorte que le transistor Tl n'est plus passant pour les coups d'horloge suivants (fig. 2d).

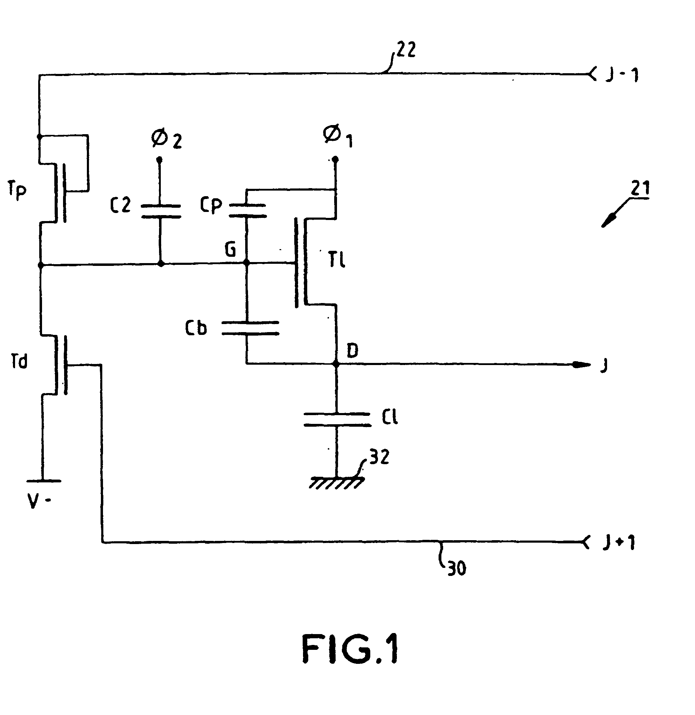

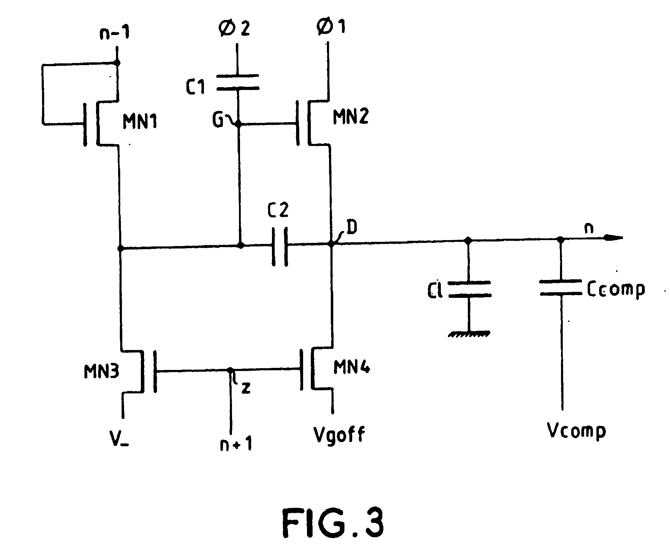

Le circuit décrit avec référence à la figure 1 a été perfectionné dans la demande de brevet français n° 94 05987 en ajoutant un transistor qui permet de travailler avec des signaux de commande ayant une amplitude de 5 à 10 volts inférieure à celle des signaux de sortie. Cette solution est représentée sur la figure 3. Sur cette figure on retrouve trois transistors MN2, MN1 et MN3 équivalents aux transistors Tl, Tp et Td, les deux entrées n- 1 et n + 1 équivalentes à J- 1 et J + 1, les deux entrées d'horloge φ1 et φ2 en opposition de phase, la sortie n de l'étage équivalente à la sortie J ainsi que les capacités C1, C2, CR correspondant respectivement aux capacités C2, Cb, CI du mode de réalisation décrit avec référence à la figure 1. Dans ce cas on prévoit un transistor de remise à zéro MN4 qui connecte le noeud D à une tension négative Vgoff. La grille du transistor MN4 est connectée au noeud Z lui-même relié à la sortie de l'étage suivant n + 1 ou à la ligne n + 2, c'est-à-dire à la ligne de sortie du second étage suivant. Comme décrit dans la demande française, une telle structure permet une remise à zéro avec un circuit simplifié. De plus, on a prévu entre la ligne de sortie n et une tension Vcomp, une capacité de compensation C comp.

La présente invention a pour objet d'apporter différents perfectionnements aux circuits décrits ci-dessus.

La présente invention est définie par la revendication 1.

D'autres caractéristiques et avantages de la présente invention apparaîtront à la lecture de la description de différents modes de réalisation faites ci-après avec référence aux dessins ci-annexés dans lesquels :
la figure 1 déjà décrite représente un étage 21 d'un registre à décalage selon l'état de l'art ;
les figures 2a A 2f représentent le chronogramme des différents signaux du dispositif de la figure 1 ;
la figure 3 déjà décrite représente un autre mode de réalisation d'un étage d'un registre à décalage selon l'art antérieur, et
les figures 4 à 5 représentent différents perfectionnements apportés à l'étage du registre à décalage représenté sur la figure 3.

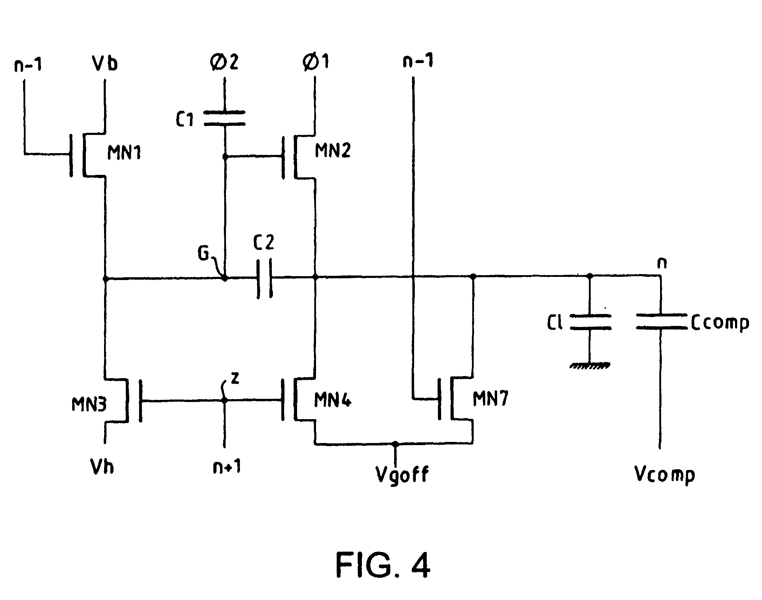

Pour simplifier la description dans les figures 4 à 5, les mêmes éléments que ceux de la figure 3, déjà décrite, portent les mêmes références.

Dans la description qui va suivre, les dispositifs semi-conducteurs sont constitués par des transistors, plus particulièrement des transistors MOS et même des TFT. L'invention n'est toutefois pas limitée à ce type de transistors.

On décrira avec référence à la figure 4, un mode de réalisation particulier qui permet à l'étage du registre à décalage de la figure 3 de fonctionner de manière bi-directionnelle. Cet étage permet de décaler les informations de l'étage n-1 vers l'étage n + 1 ou de l'étage n + 1 vers l'étage n-1 selon la polarité des tensions Vh et Vb appliquées aux électrodes des transistors MOS MN1 et MN3 utilisés respectivement pour la charge et la décharge du transistor de sortie MN2. Ainsi, comme représenté clairement sur la figure 4, la grille du transistor de précharge MN1 est connectée directement à la sortie de l'étage n-1 et une de ses électrodes connectée à la tension Vb qui peut être choisie à un niveau haut ou à un niveau bas. D'autre part, la grille du transistor de décharge MN3 est connectée de manière classique à l'étage n + 1 et une de ses électrodes connectée à la tension Vh qui est choisie à un niveau bas ou à un niveau haut en fonction de la tension Vb. Dans le mode de réalisation représenté à la figure 4, on utilise un sixième dispositif semi-conducteur MN7 connecté entre la ligne de sortie n et la tension de sortie Vgoff, pour maintenir la ligne de sortie à un niveau bas. Dans ce cas, ce dispositif semi-conducteur constitué par un transistor MOS a sa grille reliée à l'étage précédent n-1 de manière à remettre la capacité CI à la tension Vgoff à chaque fois que l'on passe de l'étage n-1 à l'étage n ou inversement.

L'étage du registre à décalage décrit avec référence à la figure 4 présente l'inconvénient d'être sensible aux fuites de courant à travers les transistors MN1 ou MN3 suivant le sens de fonctionnement. En effet, dans le mode de réalisation de la figure 3, la tension V- est en général inférieure à la tension Vgoff de façon à ce que, dans un étage non-sélectionné, le transistor de sortie MN2 ait un courant de sortie suffisamment faible pour ne pas charger la capacité CI quand l'horloge devient positive. Typiquement, pour des transistors à base de silicium amorphe, V- ≤ Vgoff - 2 volts.

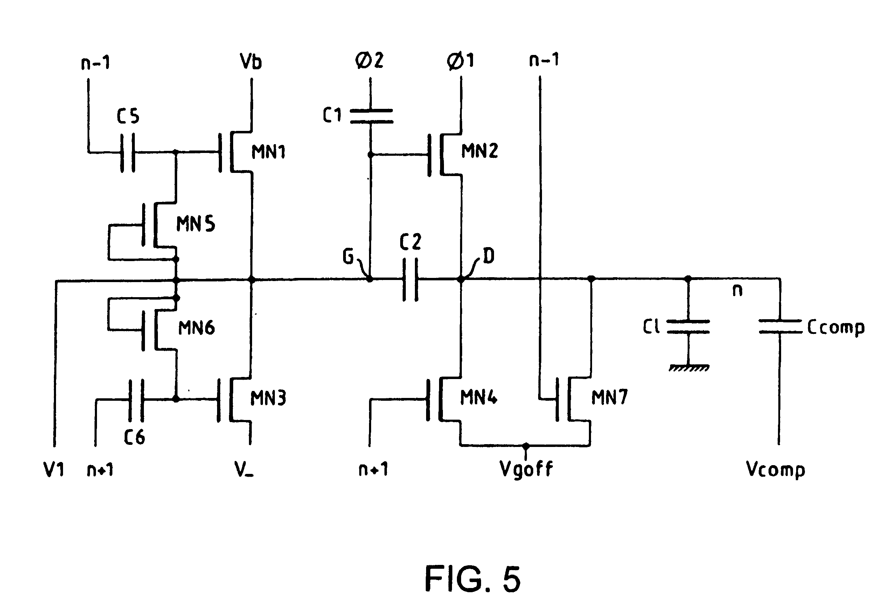

Pour remédier à cet inconvénient, on utilise la solution représentée à la figure 5. Dans ce cas, la grille du transistor MN1 est connectée à la ligne de sortie de l'étage précédent n-1 par l'intermédiaire d'une capacité de couplage C5 et un transistor MOS MN5 monté en diode est connecté entre le point commun entre la capacité C5 et la grille du transistor MN1 et le point G. De même, le transistor de décharge MN3 est connecté à l'étage suivant n+1 par l'intermédiaire d'une capacité de couplage C6 et comporte aussi une diode de "clamp" constituée par un transistor MN6. Dans le mode de réalisation de la figure 5, on voit que le noeud G est relié à la tension V1. En fait, dans les modes de réalisation des figures 4 et 5, les transistors MN1 et MN3 jouent un rôle symétrique permettant de faire fonctionner l'étage de bi-directionnelle.

Il est évident pour l'homme de l'art que les différents perfectionnements décrits ci-dessus peuvent être combinés les uns avec les autres, comme mentionnés dans les revendications ci-après.

## Revendications

1. Registre à décalage comportant une pluralité d'étages en cascade (n-1, n, n+1), chaque étage (n) comportant une sortie au niveau d'un premier noeud (D) et étant connecté à la sortie de l'étage précédent (n-1), à la sortie de l'étage suivant (n+I) et à des moyens fournissant des premier et second signaux d'horloge (φ1, φ2), ledit étage comportant un premier dispositif semi-conducteur de sortie (MN2) commutant la sortie (n) entre des valeurs hautes et basses du premier signal d'horloge (φ1), le premier dispositif semi-conducteur étant commandé par le potentiel d'un second noeud (G), lui-même connecté :
- au moyen fournissant le second signal d'horloge (φ2) à travers une première capacité ;
- à un premier potentiel (Vh) bas ou haut au travers d'un second dispositif semi-conducteur (MN3) commandé par la sortie de l'étage suivant (n + 1), et
**caractérisé en ce qu'**il est de plus connecté
- à un second potentiel haut ou bas (Vb) au travers d'un troisième dispositif semi-conducteur (MN1) commandé par la sortie de l'étage précédent (n-1).

2. Registre selon la revendication 1, **caractérisé en ce qu'**il comporte un sixième dispositif semi-conducteur (MN7) connecté entre la ligne de sortie et une tension négative (Vgoff), le sixième dispositif semi-conducteur étant commandé par la sortie de l'étage précédent.

3. Registre selon l'une quelconque des revendications 1 et 2, **caractérisé en ce que** la sortie (n) dudit étage est reliée à une tension négative (Vgoff) à travers un quatrième dispositif semi-conducteur (MN4) commandé par la sortie de l'étage suivant (n+1) ou du second étage suivant (n + 2).

4. Registre selon l'une quelconque des revendications 1 à 3, **caractérisé en ce que** :
- le second noeud (G) est connecté à la tension (V1)
- et **en ce qu'**ii comporte des moyens pour bloquer la tension de commande du second et du troisième dispositifs semi-conducteurs à une valeur inférieure ou égale à zéro.

5. Registre selon la revendication 4, **caractérisé en ce que** les moyens sont constitués par une capacité (C5, C6) connectée entre la commande dudit dispositif semi-conducteur (MN1, MN3) et le noeud (G), un cinquième et sixième dispositifs semi-conducteurs (MN5, MN6) étant connectés respectivement entre la commande du second ou du troisième dispositifs semi-conducteurs et le noeud (G), les cinquième et sixième dispositifs semi-conducteurs (MN5, MN6) étant commandés par la tension (V1) au noeud (G).

6. Registre selon l'une quelconque des revendications 1 à 5, **caractérisé en ce que** les dispositifs semi-conducteurs sont constitués par des transistors MIS, de préférence des transistors TFT.

7. Registre selon l'une quelconque des revendications 1 à 6, **caractérisé en ce que** les signaux d'horloge (φ1, φ2) sont obtenus par un même signal d'horloge en opposition de phase.

## Patentansprüche

1. Schieberegister mit mehreren in Kaskade angeordneten Stufen (n-1, n, n+1), wobei jede Stufe (n) einen Ausgang in Höhe eines ersten Knotens (D) aufweist und mit dem Ausgang der vorhergehenden Stufe (n-1), mit dem Ausgang der nachfolgenden Stufe (n+1) und mit Mitteln verbunden ist, die erste und zweite Taktsignale (φ1, φ2) liefern, wobei die Stufe eine erste Ausgangs-Halbleitervorrichtung (MN2) aufweist, die den Ausgang (n) zwischen hohen und niedrigen Werten des ersten Taktsignals (φ1) umschaltet, wobei die erste Halbleitervorrichtung vom Potential eines zweiten Knotens (G) gesteuert wird, der seinerseits verbunden ist mit:
- dem das zweite Taktsignal (φ2) liefernden Mittel über einen ersten Kondensator;
- einem ersten hohen oder niedrigen Potential (Vh) über eine zweite Halbleitervorrichtung (MN3), die vom Ausgang der nachfolgenden Stufe (n+1) gesteuert wird, und
**dadurch gekennzeichnet, dass** die Stufe weiter verbunden ist mit
- einem zweiten hohen oder niedrigen Potential (Vb) über eine dritte Halbleitervorrichtung (MN1), die vom Ausgang der vorhergehenden Stufe (n-1) gesteuert wird.

2. Register nach Anspruch 1, **dadurch gekennzeichnet, dass** es eine sechste Halbleitervorrichtung (MN7) aufweist, die zwischen die Ausgangsleitung und eine negative Spannung (Vgoff) geschaltet ist, wobei die sechste Halbleitervorrichtung vom Ausgang der vorhergehenden Stufe gesteuert wird.

3. Register nach einem der Ansprüche 1 und 2, **dadurch gekennzeichnet, dass** der Ausgang (n) der Stufe mit einer negativen Spannung (Vgoff) über eine vierte Halbleitervorrichtung (MN4) verbunden ist, die vom Ausgang der nachfolgenden Stufe (n+1) oder der zweiten nachfolgenden Stufe (n+2) gesteuert wird.

4. Register nach einem der Ansprüche 1 bis 3, **dadurch gekennzeichnet, dass**:
- der zweite Knoten (G) mit der Spannung (V1) verbunden ist
- und dass es Mittel aufweist, um die Steuerspannung der zweiten und dritten Halbleitervorrichtung auf einen Wert von höchstens Null zu blockieren.

5. Register nach Anspruch 4, **dadurch gekennzeichnet, dass** die Mittel aus einem Kondensator (C5, C6) bestehen, der zwischen die Steuerung der Halbleitervorrichtung (MN1, MN3) und den Knoten (G) geschaltet ist, wobei eine fünfte und eine sechste Halbleitervorrichtung (MN5, MN6) je zwischen die Steuerung der zweiten bzw. dritten Halbleitervorrichtung und den Knoten (G) geschaltet sind und wobei die fünfte und sechste Halbleitervorrichtung (MN5, MN6) von der Spannung (V1) des Knotens (G) gesteuert werden.

6. Register nach einem der Ansprüche 1 bis 5, **dadurch gekennzeichnet, dass** die Halbleitervorrichtungen aus MIS-Transistoren, vorzugsweise TFT-Transistoren bestehen.

7. Register nach einem der Ansprüche 1 bis 6, **dadurch gekennzeichnet, dass** die Taktsignale (φ1, φ2) durch ein gleiches Taktsignal in Gegenphase erhalten werden.

## Claims

1. Shift register containing a plurality of cascaded stages (n-1, n, n+1), each stage (n) containing an output at a first node (D) and being connected to the output of the preceding stage (n-1), to the output of the next stage (n+1) and to means delivering first and second clock signals (φ1,φ2), the said stage containing a first semiconductor output device (MN2) switching the output (n) between high and low values of the first clock signal (φ1), the first semiconductor device being controlled by the potential of a second node (G), itself connected:
- to the means delivering the second clock signal (φ2) across a first capacitance;
- to a first low or high potential (Vh) across a second semiconductor device (MN3) controlled by the output of the next stage (n+1), and
**characterized in that** it is connected moreover:
- to a second high or low potential (Vb) across a third semiconductor device (MN1) controlled by the output of the preceding stage (n-1).

2. Register according to Claim 1, **characterized in that** it includes a sixth semiconductor device (MN7) connected between the output line and a negative voltage (Vgoff), the sixth semiconductor device being controlled by the output of the preceding stage.

3. Register according to either one of Claims 1 and 2, **characterized in that** the output (n) of the said stage is linked to a negative voltage (Vgoff) across a fourth semiconductor device (MN4) controlled by the output of the next stage (n+1) or of the next but one stage (n+2).

4. Register according to any one of Claims 1 to 3, **characterized in that**:
- the second node (G) is connected to the voltage (V1)
- and **in that** it includes means for latching the control voltage of the second and third semiconductor devices at a value less than or equal to zero.

5. Register according to Claim 4, **characterized in that** the means consist of a capacitance (C5, C6) connected between the control of the said semiconductor device (MN1, MN3) and the node (G), a fifth and sixth semiconductor devices (MN5, MN6) being connected respectively between the control of the second or of the third semiconductor devices and the node (G), the fifth and sixth semiconductor devices (MN5, MN6) being controlled by the voltage (V1) at the node (G).

6. Register according to any one of Claims 1 to 5, **characterized in that** the semiconductor devices consist of MIS transistors, preferably TFT transistors.

7. Register according to any one of Claims 1 to 6, **characterized in that** the clock signals (φ1,φ2), are obtained through the same clock signal in phase opposition.
